# EUROPEAN PATENT APPLICATION

(11) **EP 4 796 967 A1**
(43) Date of publication of application: **26.08.2026**
(21) Application number: 26159012.9
(22) Date of filing: 17.02.2026
(51) Int. Cl.: G02B 6/12, H10F 30/223, H10F 77/40

(54) **PHOTODETECTOR WITH A MULTIMODE INTERFERENCE REGION, HIGH ANGLED PHOTODIODES AND REFRACTIVE-INDEX-MODIFYING REGIONS**

(30) Priority: 19.02.2025 US 202563760233 P; 19.02.2025 US 202563760239 P
(71) Applicant: Ranovus Inc., Kanata, Ontario K2K 2X1 (CA)
(72) Inventor: SHIRAN, Hatef, Ottawa, K2K 0H3 (CA); BECKETT, Douglas J. S., Kanata, K2L 1Z3 (CA); JAFARI, Omid, Ottawa, K2W 0B2 (CA); HUANTE-CERON, Edgar, Stittsville, K2S 0G2 (CA)
(74) Representative: Studio Torta S.p.A.

(57) **Abstract**

A waveguide photodetector comprises: a multimode waveguide region (MMI); an input port and plurality of output ports at opposite sides of the MMI; and for each output port:
an absorbing waveguide integrated with the main waveguide, the absorbing waveguide having an optical axis; n-doped and p-doped semiconductor region along respective opposite sides of the absorbing waveguide; an input facet at the absorbing waveguide, the input facet forming an acute angle with the optical axis, and an interior of the input facet angled towards the p-doped semiconductor region or the n-doped semiconductor region, such that at least a portion of light impinging on the input facet is refracted towards the p-doped semiconductor region or the n-doped semiconductor region. A refractive-index-modifying region is located adjacent the input facet, which comprises a region of changed refractive index relative to the main waveguide, and configured to reflect light incident thereon toward the input facet.

## Description

### CROSS-REFERENCE TO RELATED APPLICATIONS

The present specification claims priority from United States Provisional Patent Application No. 63/760233 filed on February 19, 2025, and from United States Provisional Patent Application No. 63/760239 filed on February 19, 2025, the contents of both of which are incorporated herein by reference.

### FIELD

The present specification relates generally to telecommunication devices, and specifically to photodetectors with a multimode interference region, high angled photodiodes and refractive-index-modifying regions, which maintains high bandwidth over a large range of input optical powers.

### BACKGROUND

A photodetector generally includes a photodiode that comprise a light-sensitive semiconductor diode that produces current in response to absorption of photons. Photodetectors and/or photodiodes may be discrete devices or integrated as waveguides into a photonic integrated circuit (PIC). Waveguide photodiodes may generally include a main waveguide for directing light into an absorbing waveguide of the waveguide photodiode, and may be physically located at an end of an input waveguide for delivering input light to the waveguide photodiode, which, for example, may be received from a transmitter in an optical communication system. Both the main waveguide and the absorbing waveguide of the waveguide photodiode may be generally aligned with the input waveguide for directing light into the absorbing waveguide (e.g., which converts the light into electrons and holes (e.g., electron-hole pairs) to generate a current). The input waveguide may be fabricated from silicon or silicon nitride with a dielectric cladding. The main waveguide may be fabricated from silicon with an attached, grown, and/or absorbing waveguide, and the material of the absorbing waveguide may include germanium. However, any suitable materials may be used.

The function of the absorbing waveguide is to convert the optical signal to an electrical signal. The absorbing waveguide is generally connected to positive and negative contacts. For example absorbing waveguide includes an absorbing region disposed between p-type and n-type contacts, where the p-type contact comprises a semiconductor region having holes as majority carriers and the n-type contact comprises a semiconductor region having electrons as majority carriers. The electrical signal may be transmitted to an amplifier on or off a PIC.

The absorbing waveguide is both transmissive and absorbing. In optical or electromagnetic terms, the material has a complex refractive index, having both real and complex components.

Absorbed light inside the absorbing material creates electron-hole (e.g., "e-h") pairs. The e-h pairs are then collected by via an applied electric field between p-n contacts. However, the e-h pairs also generate an electric field opposite to the applied electric field between the p-n contacts. When the optical input power to the device is low, the number of generated e-h pairs is low; thus, the e-h pairs electric field is negligible compared to the applied electric field. However, as the input lights becomes larger, the electric field generated by an increasing number of the generated e-h pairs causes a total electric field (e.g., the applied electric field and the e-h electric field) to drop, which generally reduces device bandwidth drastically even to a few Gigahertz which is insufficient in modern optical transceiver systems.

On the other hand, the overall absorption of the light by the photodiode (e.g., responsivity) need to be kept high, as modern optical receivers need to operate over a large range of optical input powers. Photodiodes with insufficient responsivity cannot detect light in low optical input powers.

### BRIEF DESCRIPTIONS OF THE DRAWINGS

For a better understanding of the various implementations described herein and to show more clearly how they may be carried into effect, reference will now be made, by way of example only, in which:
FIG. 1 depicts a top view photodiode with a high angled input facet of an absorbing waveguide, relative to an input waveguide, and a refractive-index-modifying region that reflects light, that is reflected from the input facet, at least partially back into the input facet, according to present examples.
FIG. 2A depicts the photodiode of FIG. 1 in operation for expanded light, according to present examples.
FIG. 2B depicts the photodiode of FIG. 1 in operation for reflected light, according to present examples.
FIG. 3A depicts a cross-section of the photodiode of FIG. 1 through a line A-A', according to present examples.
FIG. 3B depicts a cross-section of the photodiode of FIG. 1 through a line B-B', according to present examples.
FIG. 3C depicts a cross-section of the photodiode of FIG. 1 through a line C-C', according to present examples.
FIG. 4 depicts: a graph of relative absorbed power as a function of length along a propagation axis of the photodiode of FIG. 1 with an input angle of 70° relative to a line that is at 90° to an axis of an input waveguide, according to present examples; and a graph of relative absorbed power as a function of length along a propagation axis of a photodiode according to the prior art, with an input angle of 0° relative to a line that is at 90° to an axis of an input waveguide.

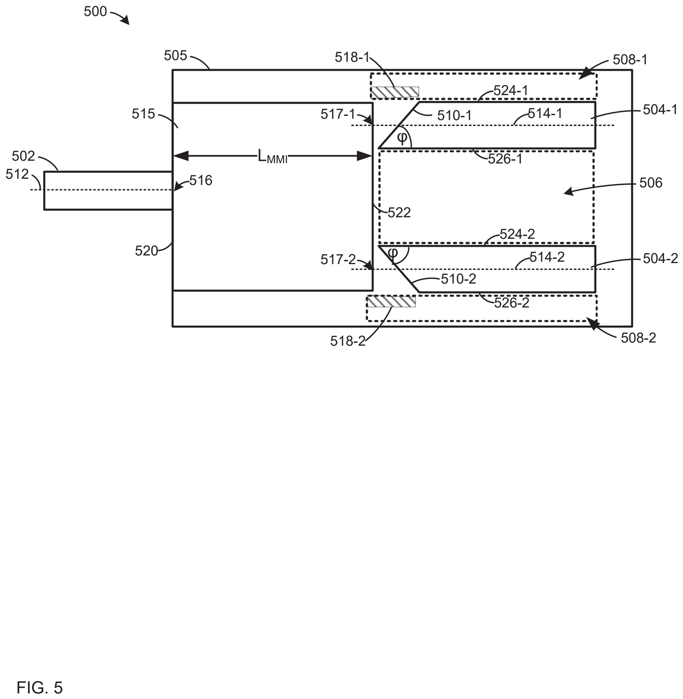

FIG. 5 depicts a top view of a photodetector with a multimode interference region fabricated on a main waveguide, and that splits light input by an input waveguide into at least two portions, with a corresponding number of absorbing waveguides positioned to receive respective light of the least two portions and convert the respective light into photocurrent; each photodiode includes a high angled input facet of an absorbing waveguide, and a refractive-index-modifying region that reflects light, that is reflected from the input facet, at least partially back into the input facet, according to according to present examples.
FIG. 6 depicts a photodetector, similar to the photodetector of FIG. 5, but with a different configuration of the input facets, according to present examples.
FIG. 7 depicts a photodetector, similar to the photodetector of FIG. 5, but with yet a different configuration of the input facets, according to present examples.
FIG. 8 depicts a photodetector, similar to the photodetector of FIG. 5, but with yet a different configuration of the input facets, according to present examples.

### DETAILED DESCRIPTION

In the present disclosure, gradual absorption of light over a long length of absorption region of a photodiode may be provided using angled input facets of absorbing waveguides, thus avoiding an electric field drop by an excessive number of e-h pairs at a local region. Also, by introducing refractive-index-modifying regions, light is generally guided towards an input facet of the absorbing region, preventing light reflected from the input facet from escaping. The introduction of this refractive-index-modifying region may hence keep the responsivity of the photodiode high.

Indeed an aspect of the present specification provides a waveguide photodiode comprising: a main waveguide; an absorbing waveguide integrated with the main waveguide, one or more of the absorbing waveguide and the main waveguide having an optical axis; an n-doped semiconductor region along a first side of the absorbing waveguide; a p-doped semiconductor region along a second side of the absorbing waveguide, the second side opposite the first side; and an input facet at the absorbing waveguide, the input facet forming an acute angle with the optical axis, and an interior of the input facet angled towards the p-doped semiconductor region or the n-doped semiconductor region, such that at least a portion of light impinging on the input facet is refracted towards the p-doped semiconductor region or the n-doped semiconductor region; and a refractive-index-modifying region located adjacent to the input facet, the refractive-index-modifying region comprising a region of changed refractive index relative to the main waveguide, the refractive-index-modifying region configured to reflect respective light incident thereon toward the input facet.

Another aspect of the present specification provides a waveguide photodetector comprising: a multimode waveguide region; an input port at a first side of the multimode waveguide region; a plurality of output ports at a second side of the multimode waveguide region, the second side opposite the first side; a main waveguide; and for each output port: an absorbing waveguide integrated with the main waveguide, the absorbing waveguide having an optical axis; an n-doped semiconductor region along a respective first side of the absorbing waveguide; a p-doped semiconductor region along a respective second side of the absorbing waveguide, the respective second side opposite the respective first side; an input facet at the absorbing waveguide, the input facet forming an acute angle with the optical axis, and an interior of the input facet angled towards the p-doped semiconductor region or the n-doped semiconductor region, such that at least a portion of light impinging on the input facet is refracted towards the p-doped semiconductor region or the n-doped semiconductor region; and a refractive-index-modifying region located adjacent to the input facet, the refractive-index-modifying region comprising a region of changed refractive index relative to the main waveguide, the refractive-index-modifying region configured to reflect respective light incident thereon toward the input facet.

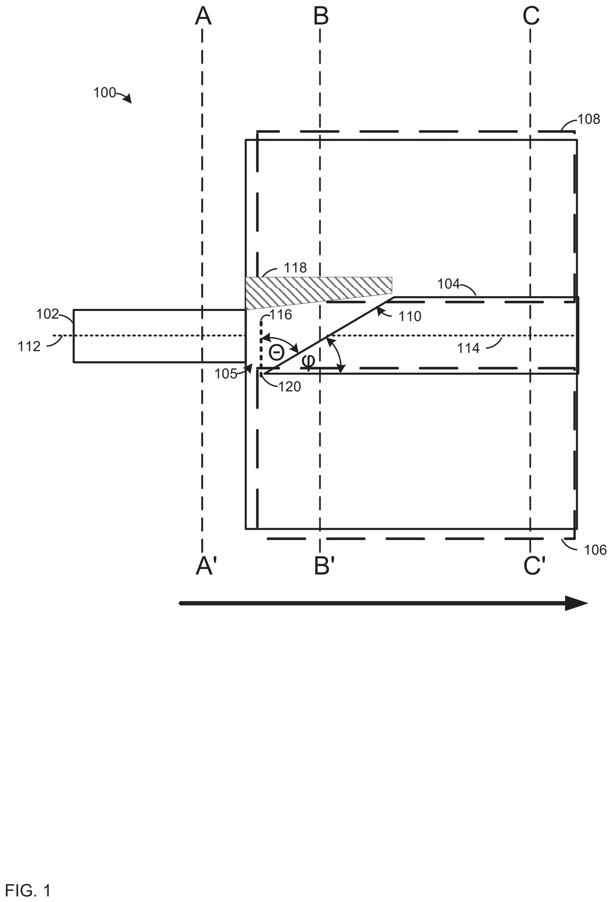

Attention is first directed to FIG. 1, which depicts an example of a photodiode 100 comprising an input waveguide 102, an absorbing waveguide 104 (e.g., a photodiode) integrated with a main waveguide 105, with a p-contact 106 (p-doped semiconductor region) and an n-contact 108 (n-doped semiconductor region) on opposite sides of the absorbing waveguide 104. The terms p-contact 106 and p-doped semiconductor region 106 will be used interchangeably herein, and similarly the terms n-contact 108 and n-doped semiconductor region 108 will be used interchangeably herein. While the input waveguide 102 and the main waveguide 105 may comprise silicon, and the p-n contacts 106, 108 may respectively comprise p-doped silicon and n-doped silicon, any suitable materials may be used. For example, the absorbing waveguide 104 may comprise a germanium-based photodetector.

As depicted it, the absorbing waveguide 104 comprises an input facet 110, and the waveguides 102, 104 comprise respective optical axes 112, 114. It is understood that that the p-n contacts 106, 108are on opposite sides of the absorbing waveguide 104 relative to the optical axis 114. When light impinges on the input facet 110 from the input waveguide 102, for example along the optical axes 112, 114, at least a portion of the light enters the absorbing waveguide 104 where it is converted to charge (e.g., e-h pairs), which is collected by the p-n contacts 106, 108 (e.g., electrons flow to the n-contact 108 and holes flow to the p-contact 106, assisted by an applied electric field), and detected as current which may be proportional to power and/or intensity of the light from the input waveguide 102.

It is furthermore understood that the input facet 110 is not at 90° to the optical axes 112, 114, but is at an acute (e.g., less than 90°) angle, as is next described.

While the angle of the input facet 110 may be characterized relative to various features of the waveguides 102, 104, as depicted, a line 116 is shown that is at 90° to the optical axes 112, 114, and is where the input facet 110 would be located if the input facet 110 were perpendicular to the optical axes 112, 114. Alternatively or in addition, the angle of the input facet 110 may be characterized relative to an angle φ formed by the input facet 110 and the optical axis 114 and/or a side of the absorbing waveguide 104 parallel to the optical axis 114 (e.g., as depicted, adjacent the p-contact 106).

Also depicted is an angle Θ to the line 116 at which the input facet 110 is angled relative to the line 116, and the angle Θ may be in a range of about 60° to about 80°, which may be a "high angle". Conversely, the angle φ may be in a range of about 30° to about 10° (e.g. such that the angles Θ, φ add to 90°)

As such, an input area of the input facet 110 increases relative to if the input facet 110 were at 0° to the line 116 (e.g., 90° to the optical axes 112, 114). In particular, the angle Θ being in a range of about 60° to about 80° may increase the area over which light impinges on the absorbing waveguide 104, for example when light from the input waveguide 102 impinges on the input facet 110, and furthermore the angle Θ being in a range of about 60° to about 80° may increase the area over which light entering the absorbing waveguide 104 is absorbed.

Furthermore, a direction of the angle Θ and/or the angle φ is such that the light impinging on the input facet 110 (e.g., along the axes 112, 114) is directed towards the p-contact 106 to increase the bandwidth of the device.

Electron hole pairs generated in the absorbing waveguide 104 are separated by an applied electric field between the p-n contacts 106, 108. In such a configuration, (the angle Θ being in a range of about 60° to about 80° angled toward the p-contact 106), light is directed (e.g., refracted) towards the p-contact 106, increasing a proportion of generated e-h pairs that are nearer to the p-contact 106, and therefore decreasing the travel distance for holes to the p-contact 106.

When the photodiode 100 is silicon-based and/or germanium-based, it is understood that the mobility of holes in silicon and/or germanium may be severely limited; as such, when the photodiode 100 is silicon-based and/or germanium-based, the angling of the input facet 110 is generally such that light impinging on the input facet 110 is refracted towards the p-contact 106 so that e-h pairs are generated in the absorbing waveguide 104 closer to the p-contact 106 than the n-contact 108. If the input facet 110 was angled such that light impinging on the input facet 110 is refracted towards the n-contact 108, holes generated would have a longer path to travel through undoped silicon to reach the n-contact 108, which may cause the bandwidth of the photodiode 100 to decrease. However, it is further understood that in other materials, the mobility of electrons may be more limited than that of holes (e.g., GaSb (Gallium Antimonide), some organic semiconductors, and the like); in these examples, the angling of the input facet 110 is generally such that light impinging on the input facet 110 is refracted towards the n-contact 108 so that e-h pairs are generated in the absorbing waveguide 104 closer to the n-contact 108 than the p-contact 106.

Hence, while examples are described herein with an interior of the input facet 110 angled towards the p-doped semiconductor region (e.g., the p-contact 106), such that light input to the input facet 110 is refracted towards the p-doped semiconductor region (e.g., the p-contact 106), in other examples, an interior of the input facet 110 may angled towards the n-doped semiconductor region (e.g., the n-contact 108), such that light input to the input facet 110 is refracted towards the n-doped semiconductor region (e.g., the n-contact 108).

Put another way, the photodiode 100 comprises: a main waveguide 105; an absorbing waveguide 104 integrated with the main waveguide 105, one or more of the absorbing waveguide 104 and the main waveguide 105 having an optical axis 114; an n-doped semiconductor region (e.g., the n-contact 108) along a first side of the absorbing waveguide 104; a p-doped semiconductor region (e.g., the p-contact 106) along a second side of the absorbing waveguide 104, the second side opposite the first side; and an input facet 110 at the absorbing waveguide, 104 the input facet 110 forming an acute angle φ with the optical axis 114, and an interior of the input facet 110 angled towards the p-doped semiconductor region (e.g., the p-contact 106) or the n-doped semiconductor region (e.g., the n-contact 108), such that light input to the input facet 110 is refracted towards the p-doped semiconductor region (e.g., the p-contact 106) or the n-doped semiconductor region (e.g., the n-contact 108).

Furthermore, in some instances, when the photodiode 100 is silicon-based and/or germanium-based, for example when the photodiode 100 is adapted as an electron-optimized avalanche photodiode (APD), electron detection may be emphasized over hole detection, and the input facet 110 may be generally angled such that light impinging on the input facet 110 is refracted towards the n-contact 108 so that e-h pairs are generated in the absorbing waveguide 104 closer to the n-contact 108 than the p-contact 106 (e.g., electrons may be multiplied in an avalanche region while holes may not multiplied in the avalanche region, presuming the n-contact 108 is adapted to comprise an avalanche region). For example, adapting the photodiode 100 is adapted as an electron-optimized avalanche photodiode may include, but is not limited to, separate absorption and multiplication layers (SAM), graded materials and/or doping layers (Separate Absorption, Grading, and Multiplication (SAGM)), a delta-doped charge sheet (Separate Absorption, Grading, Charge, and Multiplication (SAGCM)). Such multiplication layers, graded multiplication layers, and/or graded charge multiplication layers may precede an n-contact or a p-contact but are generally on one side or the other (i.e. towards the n-contact or the p-contact). As such, the input facet 110 may be generally angled such that light impinging on the input facet 110 is refracted towards the n-contact 108 or the p-contact 106 depending on the configuration of the APD.

As light enters the main waveguide 105 from the input waveguide 102, the light starts expanding and a portion of the light may be lost by entering into the n-contact 108. Also, another portion of light impinging on the input facet 110 may be reflected away from the input facet 110 due to the change in index of refraction between the main waveguide 105 and the absorbing waveguide 104.

To contain the expanded and/or the reflected light, the photodiode 100 further comprises a refractive-index-modifying region 118 located adjacent to the input facet 110. In particular, as the input facet 110 and the line 116 form the angle Θ, and light reflected from the input facet 110 will be reflected away from the input facet 110 through the main waveguide 105 and away from a vertex 120 of the angle Θ formed by the input facet 110 and the line 116, the refractive-index-modifying region 118 is understood to be located away from the vertex 120 in a direction of the reflected light. The refractive-index-modifying region 118 is further understood to be located outside of a path of light impinging on the input facet 110 from the input waveguide 102.

In particular, the refractive-index-modifying region 118 may comprise an absence of main waveguide material (e.g., silicon), such as a trough in the main waveguide 105 (e.g., etched into the main waveguide 105) that causes an abrupt change in an index of refraction in the main waveguide 105 in a direction of the reflected light. For example, when the main waveguide 105 comprises silicon, the refractive-index-modifying region 118 may comprise an absence of silicon and/or a trough in the silicon, that may be filled with air and/or an oxide material and/or a transparent material (e.g., a transparent oxide) and/or a semitransparent material (e.g., a semitransparent oxide material) to cause the change in the index of refraction in a direction of the reflected light. As used herein, a transparent (e.g., oxide) material refers to an (e.g., oxide) material that transmits a substantial portion of incident optical radiation with negligible absorption at an operating wavelength, whereas a semitransparent (e.g., oxide) material refers to an (e.g., oxide) material that transmits a portion of the incident optical radiation while exhibiting non-negligible absorption and/or scattering at the operating wavelength. Such an operating wavelength may be the wavelength of the light received via the input waveguide 102.

In particular, an index of refraction of the refractive-index-modifying region 118 may be less than a respective index of refraction of the main waveguide 105 to cause light impinging on the refractive-index-modifying region 118 to be reflected towards the input facet 110.

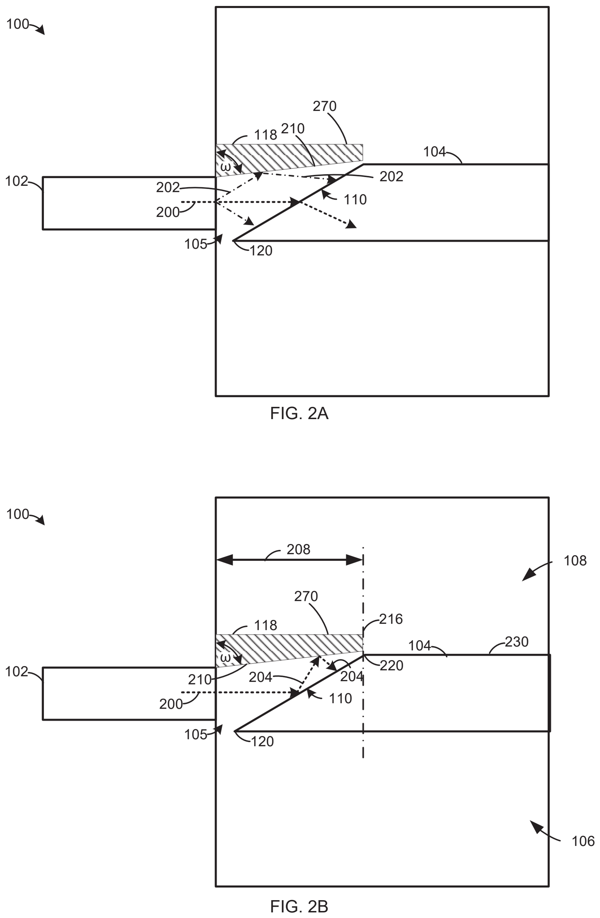

In one example, and with attention directed to FIG. 2A, which depicts the photodiode 100 with only certain components for simplicity (though all components are understood to be present), light 200 from the input waveguide 102 (e.g., a narrow single mode waveguide) that enters the main waveguide 105 (e.g., a wide slab-mode waveguide), starts expanding. Most of the light 200 impinges on the input facet 110, and is refracted into the absorbing waveguide 104. However a portion 202 of the light 200 (e.g., a tail of the wave of the light 200) may not impinge on the input facet 110, but rather may "escape" the region between the input facet 110 and the input waveguide 102, leaking into the n-doped semiconductor region and/or n-contact 108. In this example, the refractive-index-modifying region 118 generally reflects such a portion 202 of expanded light towards the input facet 110. It is noted that the portion 202 of the expanded light expands about equally towards the p-doped semiconductor region and/or p-contact, and the n-doped semiconductor region and/or n-contact 108. However, the expanded light travelling towards the p-doped semiconductor region and/or p-contact 106 generally impinges on the input facet 110 due to the input facet 110 being angled such that the vertex 120 is closer to the input waveguide 102, adjacent the p-doped semiconductor region and/or p-contact 106.

In another example, and with attention directed to FIG. 2B, which depicts the photodiode 100 with only certain components for simplicity (though all components are understood to be present), the light 200 from the input waveguide 102 enters the main waveguide 105 and impinges on the input facet 110. Most of the light 200 impinges on the input facet 110, and is refracted into the absorbing waveguide 104. However, a portion 204 of the light 200 may be reflected from the input facet 110 towards the refractive-index-modifying region 118. In this example, the refractive-index-modifying region 118 generally reflects such a reflected portion 204 of the light 200 back towards the input facet 110.

As such, it is understood that the refractive-index-modifying region 118 generally contains light reflected from the input facet 110 (e.g., angled at the angle Θ) in the region between the refractive-index-modifying region 118 and the input facet 110, thereby increasing the amount of light 200 that enters the input facet 110 (e.g., upon successive reflections).

Furthermore, an angle ω of a side 210 of the refractive-index-modifying region 118 that is adjacent the region of the main waveguide 105 between the input facet 110 and the input waveguide 102, relative to a line perpendicular to the optical axes 112, 114, may be selected heuristically to promote reflection of the portions 202, 204 from the refractive-index-modifying region 118 towards the input facet 110. For example, such an angle ω may be in a range of about 0° to about 10°, but may generally depend on the angles φ, Θ, at least for the portion 204.

It is further understood that both portions 202, 204 may be present and hence the examples depicted in FIG. 2A and FIG. 2B may occur simultaneously.

Furthermore, it is understood that the refractive-index-modifying region 118 may furthermore reflect further reflections from the input facet 110 back towards the input facet 110 (e.g., when the portions 202, 204 reflect from the input facet 110 after being directed towards the input facet 110 by the refractive-index-modifying region 118).

Dimensions and/or a physical configuration of the refractive-index-modifying region 118 are next described.

For example, from both FIG. 2A and FIG. 2B it is apparent that the refractive-index-modifying region 118 is outside a path of the light 200, other than the portion 202 (e.g., a tail of the wave of the light 200).

With reference to FIG. 2B, it is further understood that a length 208 of the refractive-index-modifying region 118 for example in a direction of the optical axes 112, 114, may be about the same and/or similar to a longest distance between the input facet 110 and the input waveguide 102. For example, as depicted in in FIG. 2B, a line 216 is depicted perpendicular to the optical axes 112, 114 and through a point 220 where the input facet 110 intersects with an edge 230 of the remainder of the absorbing waveguide 104, that is adjacent the n-doped semiconductor region and/or n-contact 108 and parallel to the optical axes 112, 114. The point 220 may be at end of the input facet 110 that is opposite the vertex 120. As depicted, the length 208 of the refractive-index-modifying region 118 may about the same as and/or similar to a perpendicular distance from the input facet 110 (e.g., where the input facet 102 is adjacent the main waveguide 105) to the line 216.

In general, the refractive-index-modifying region 118 may not extend into the region of n-doped semiconductor region and/or n-contact 108 that is adjacent the edge 230 so that the refractive-index-modifying region 118 does not interfere with and/or block electrons entering the n-doped semiconductor region and/or n-contact 108 from the edge 230. However, the refractive-index-modifying region 118 may extend partially into the n-doped semiconductor region and/or n-contact 108 due to manufacturing tolerances, and the like.

Put another way, a length 208 of the refractive-index-modifying region 118 may be between about 5% and 10% longer than the perpendicular distance from the input facet 110 to the line 216, presuming the edge 230 is longer than the length 208 of the refractive-index-modifying region 118 (e.g., 1.5x longer, 2x longer, 3x longer, amongst other possibilities). Indeed, it is understood that the photodiode 100 is not drawn to scale herein and the length of the edge 230 may be significantly longer than the length 208 of the refractive-index-modifying region 118.

Furthermore, a width of the refractive-index-modifying region 118, between the side 210 and a side 270 opposite the side 210, may be any suitable width, which may vary across the length of the refractive-index-modifying region 118. In general, however, the width of the refractive-index-modifying region 118 may be selected heuristically so that reflection of the portions 202, 204 occur. In some examples, the width of the refractive-index-modifying region 118 may be at least about 0.3 µm to better ensure that light impinging on the refractive-index-modifying region 118 is reflected, however any suitable width is within the scope of the present specification.

Furthermore, while the angle ω of the refractive-index-modifying region 118 may be selected to optimize the reflection of light impinging on side 210 of the refractive-index-modifying region 118 into the input facet 110, a side 270 opposite the side 210 may be any suitable shape. While as depicted the side 270 is straight and parallel to the optical axes 112, 114, the side 270 may have any suitable shape (e.g., straight, curved, irregular, amongst other possibilities) and/or be at any suitable angle to the optical axes 112, 114.

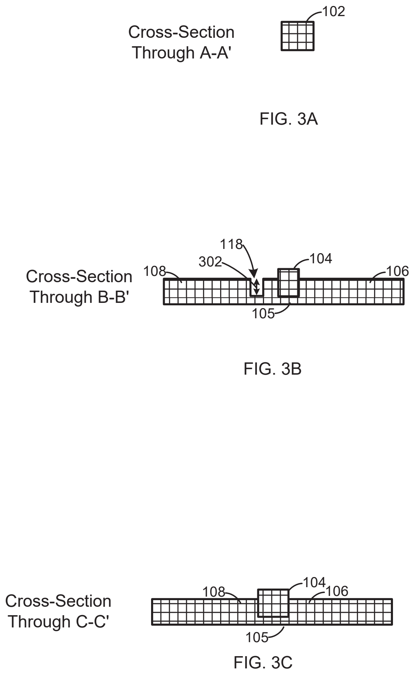

Attention is next directed to FIG. 3A, FIG. 3B and FIG. 3C, which respectively depict a cross-section of the photodiode 100 through lines A-A', B-B', C-C' of FIG. 1.

With specific attention to FIG. 3B, it is understood that a depth 302 of the refractive-index-modifying region 118 may be about half a respective depth of the main waveguide 105 or more (e.g., as depicted).

Indeed, in the event that electrons generated by the absorbing waveguide 104 at the surface of the input facet 110 impinge on the refractive-index-modifying region 118, the refractive-index-modifying region 118 may block, or at least partially constrict, such electrons from entering the n-doped semiconductor region (e.g., the n-contact 108). Similar blocking and/or constricting may occur when the refractive-index-modifying region 118 extends past the line 216. Furthermore, similar to the width of the refractive-index-modifying region 118, if the depth 302 is "too shallow", light impinging on the refractive-index-modifying region 118 may not reflect towards the input facet 110.

Hence, the depth 302, the length 208 and the width of the refractive-index-modifying region 118 may be heuristically selected to both: maximize reflection of light impinging on the refractive-index-modifying region 118 towards the input facet 110; and maximize electron current to the n-doped semiconductor region (e.g., the n-contact 108).

Put another way, the depth 302, the length 208 and the width of the refractive-index-modifying region 118 may be heuristically selected to maximize the bandwidth of the photodiode 100.

Furthermore, while as depicted in FIG. 3B, the refractive-index-modifying region 118 comprises a trough, and the like, in the main waveguide 105 that extends into the main waveguide 105 at a same side as the absorbing waveguide 104, in other examples, the refractive-index-modifying region 118 may extend into the main waveguide 105 at a side opposite a respective side of the absorbing waveguide 104.

Put another way, a geometry the refractive-index-modifying region 118 may be any suitable geometry.

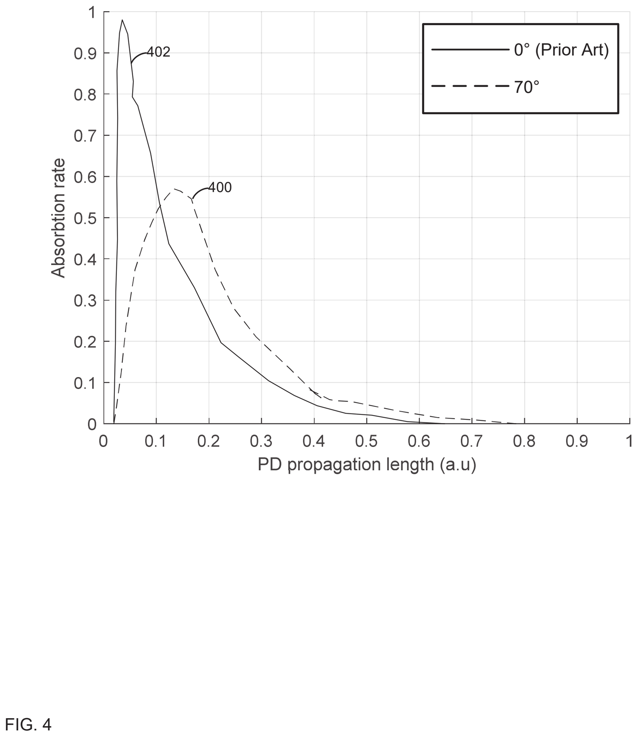

Attention is next directed to FIG. 4, which depicts a graph 400 (e.g., a broken line) of relative absorbed rate of (e.g., power) of light as a function of relative length along a propagation axis (e.g., optical axis 114) of the photodiode 100 of FIG. 1 with an input angle Θ of 70° relative to the line 116 that is at 90° to the optical axis 112 of the input waveguide 102.

For comparison, FIG. 4 further depicts a graph 402 (e.g., a solid line) of relative absorbed rate of (e.g., power) of light as a function of relative length along a propagation axis of a photodiode according to the prior art, with an input angle of 0° relative to a line that is at 90° to an axis of an input waveguide (e.g., and without an etched region).

Comparing the graphs 400, 402 it is apparent that more of the light is absorbed deeper into the photodiode 100 as compared to prior art photodiodes. Indeed, the two graphs 400, 402 shows more light is absorbed overall in the photodiode 100 as compared to a prior art photodiode.

Indeed, in the prior art, when the e-h pairs are generated at the surface of an input facet of an absorbing waveguide and/or in the absorbing waveguide the e-h pairs generate an opposing electric field to the applied field between p-n contacts, thus, resulting in a weaker electric field and a weaker overall bandwidth of the device. This phenomenon shows itself as a drop in device bandwidth with increasing the amplitude of the optical power.

However, in the present specification, and with reference to the graph 400, absorption clearly occurs over a greater depth in the photodiode 100, relative to the prior art, which may enable the photodiode 100, to maintain a bandwidth strength over larger input powers, at least as compared to a photodiode of the prior art.

Attention is next directed to FIG. 5, which depicts an example of a waveguide photodetector 500 comprising an input waveguide 502, a pair of absorbing waveguides 504-1, 504-2 integrated with a main waveguide 505. The absorbing waveguides 504-1, 504-2 are interchangeably referred to hereafter, collectively, as the absorbing waveguides 504 and, generically, as an absorbing waveguide 504; this convention. This convention will be used elsewhere in the present specification. Furthermore, the pair of absorbing waveguides 504 correspond to a pair of photodiodes.

Furthermore, the waveguide photodetector 500 further comprise: a p-contact 506 (e.g., interchangeably referred to as a p-doped semiconductor region 506) between the absorbing waveguides 504 and respective n-contacts 508-1, 508-2 (e.g., n-contacts 508 and/or an n-contact 508, and interchangeably referred to as respective n-doped semiconductor regions 508) on respective sides of the absorbing waveguides 504 opposite that of the p-contact 506. The p-contact 506 is hence understood to act as a p-contact for both absorbing waveguides 504 and/or the absorbing waveguides 504 are understood to share a p-doped semiconductor region 506.

The doped semiconductor regions are generally indicated in FIG. 5 by boxes drawn in broken lines merely to indicate they are present; however, the doped semiconductor regions are understood to have any suitable geometry.

While the input waveguide 502 and the main waveguide 505 may comprise silicon and the p-n contacts 506, 508 comprise p-doped and n-doped silicon, the absorbing waveguides 504 may comprise a germanium-based photodiode, and/or any other suitable materials.

As depicted it, the absorbing waveguides 504 comprise respective input facets 510-1, 510-2 (e.g., input facets 510 and/or an input facet 510), the input waveguides 502 comprises an optical axis 512, and the absorbing waveguides 504 comprise respective optical axes 514-1, 514-2 (e.g., optical axes 514 and/or an optical axis 514).

It is understood that respective p-n contacts 506, 508 are on opposite sides of a given absorbing waveguide 504 relative to a respective optical axis 514. When light impinges on a respective input facet 510, for example along a respective optical axis 514, at least a portion of the light enters a respective absorbing waveguide 504 where it is converted to e-h pairs, which are collected by the p-n contacts 506, 508, and detected as current which may be proportional to power and/or intensity of the light. Indeed, the operation of the absorbing waveguides 504 is similar to that of the absorbing waveguide 104 of the photodiode 100.

While as depicted the input facets 510 are not at 90° to the respective optical axes 514, in some examples, one or both of the input facets 510 may be at 90° to a respective optical axis 514, similar to the input facet 110 of the photodiode 100 and hence features of the input facets 510 are understood to be similar to features described with respect to the input facet 110. Indeed, like the input facet 110, an interior of the input facets may be angled towards a p-doped semiconductor region or an n-doped semiconductor region. Indeed, similar to the photodiode 100, the waveguide photodetector 500 may be adapted as a pair of avalanche photodiodes.

As depicted, the waveguide photodetector 500 further comprises a multimode interference (MMI) region 515 located on the main waveguide 505 between the input waveguides 502 and the absorbing waveguides 504. The MMI region 515 is positioned to receive light from the input waveguide 502 for example at an input port 516 aligned with, and/or centered on, the optical axis 512 of the input waveguide 502. Through a multimode inference effect, the MMI region 515 generates two images of the input light, at a perpendicular distance L_{MMI} from an input port 516 to the MMI region 515, one image at each of two respective output ports 517-1, 517-2 (e.g., output ports 517 and/or an output port 517) of the MMI region 515. Each of the images of the input light, output at the output ports 517, are at about half the power of the input light. The input facets 510 of the absorbing waveguides 504 are positioned to receive the images (e.g., light) and the absorbing waveguides 504 which convert the images to photocurrent, similar to as described with respect to the photodiode 100. Indeed, the output ports 517 are each respectively aligned with, and/or centered on, respective optical axes 514 of the absorbing waveguides 504.

Put another way, the MMI region 515 comprises an optical waveguide structure that supports multiple propagation modes and uses self-interference of the modes to split, combine, or distribute optical signals/light, for example, as depicted, into two images that respectively impinge on each of the input facets 510 via respective output ports 517.

In general, the MMI region 515 may be fabricated on, and/or at, the main waveguide 505 using any suitable fabrication techniques.

Such a splitting of the input light into two images generally halves the power of respective light input to the absorbing waveguides 504, thereby decreasing a possibility of saturation in the absorbing waveguides 504.

As depicted, the input facets 510 are at respective angles φ to the respective optical axes 514 (e.g., rather than 90°, and such angles φ may between about 30° to about 10° and, more particularly, between about 50° and about 45°, for example to increase an area of the input facets 510, which in turn may increase absorption of light of the images, similar to the photodiode 100. Furthermore, a direction of the angle φ is such that the light impinging on the input facet 510 (e.g., along the axes 512, 514) is directed towards the p-contact 506.

As the light impinges on the input facets 510, the light is absorbed on the surface of the input facets 510 of respective absorbing waveguides 504, and, along the length of the absorbing waveguides 504. Generated e-h pairs are separated by an applied electric field across the p-n contacts 506, 508 and move towards respective p-n contacts 506, 508. By angling the input facets 510 of the absorbing waveguides 504 toward the p-contact 506, the surface generated holes travel through the absorbing waveguides 504 and the surface generated electrons travel through the main waveguide 505 to reach a respective n-contact 508. In the case of a Si-Ge photodiode, the mobility of holes in germanium is much higher than the mobility of holes in silicon; thus, such angling direction helps to increase the bandwidth.

Generated e-h pairs travelling along the length of the absorbing waveguides 504 travel are separated to reach the respective p-n contacts 506, 508. Due to the p-direction angling of the input facets 510 of the absorbing waveguides 504, the incident light is refracted toward the p-contact 506, thus, generating the e-h pairs nearer the p-contact 506. In the case of a Si-Ge photodiode, as the mobility of electrons is higher than holes inside germanium, less mobile holes need to travel a shorter distance toward the p-contact 506 which, again, increases the bandwidth.

While as depicted, the p-contact 506 is common between the two absorbing waveguides 504 and respective n-contacts 508 are on each side of the absorbing waveguides 504 (e.g., opposite the p-contact 506), it is understood that the n-contacts 508 may be connected so that the photodetectors formed by the absorbing waveguides 504 may act like a single p-n diode and/or photodetector. In this connection approach, the two absorbing waveguides 104 are connected in parallel, resulting in higher output current, but this may come at a cost of higher output capacitance: in particular the absorbing waveguides 104 are connected in parallel and hence the total capacitance is twice the capacitance of each absorbing waveguides 104 (e.g., p-n junctions thereof).

Also similar to the photodiode 100, to keep the light guided toward the absorptive material of 504, the waveguide photodetector 500 further comprises respective refractive-index-modifying regions 518-1, 518-2 (e.g., refractive-index-modifying regions 518 and/or a refractive-index-modifying region 518) located adjacent to respective input facets 510 and outside a path of the images output by the MMI region 515. The refractive-index-modifying regions 518 are similar to the refractive-index-modifying region 118 of the photodiode 100.

Indeed, the waveguide photodetector 500 generally functions similar to the photodiode 100, though the waveguide photodetector 500 generally comprises components corresponding to a pair of photodiodes, similar to the photodiode 100, with the MMI region 515 separating light from the input waveguide 502 into two images.

In particular, similar to the refractive-index-modifying region 118, a refractive-index-modifying region 518 may comprise a trough in the main waveguide 505 (e.g., etched into the main waveguide 505) that causes an abrupt change in an index of refraction in the main waveguide 505 in a direction of light from a respective input facet 510, and a direction of a tail of a wave of the light impinging on an input facet 510. For example, when the main waveguide 505 comprises silicon, the refractive-index-modifying region 518 may comprise a trough in the silicon, that may be filled with a transparent and/or semitransparent oxide material, and/or air, to cause the change in the index of refraction, similar to the refractive-index-modifying region 518. Indeed, the refractive-index-modifying regions 518 may be similar to the refractive-index-modifying region 118 of the photodiode 100, with similar features described herein with respect to the refractive-index-modifying region 118 of the photodiode 100.

It is yet further understood that while the MMI region 515 is depicted with two output ports 517, and hence is configured to generate two images at respective output ports 517, the MMI region 515 the may be configured to generate any suitable "N" number of images of light input to the MMI region 515 by the input waveguide 502, with the MMI region 515 adapted to include "N" output ports 517. Similarly, the waveguide photodetector 500 may be adapted to include a same "N" number of absorbing waveguides 504. where "N" is two or more.

Indeed, power of each image input to a respective absorbing waveguide 504 may be the total power of the light input to the MMI region 515 divided by "N", which may further decrease a possibility of saturation in the absorbing waveguides 504. In these example, respective input facets 510 of each of "N" absorbing waveguides 504 are positioned to accept a respective image from the MMI region 515. Put another way, the waveguide photodetector 500 may be scalable to "N" absorbing waveguide 504 and/or photodiodes by using an MMI region 515 that generates "N" number of images of light input to the MMI region 515.

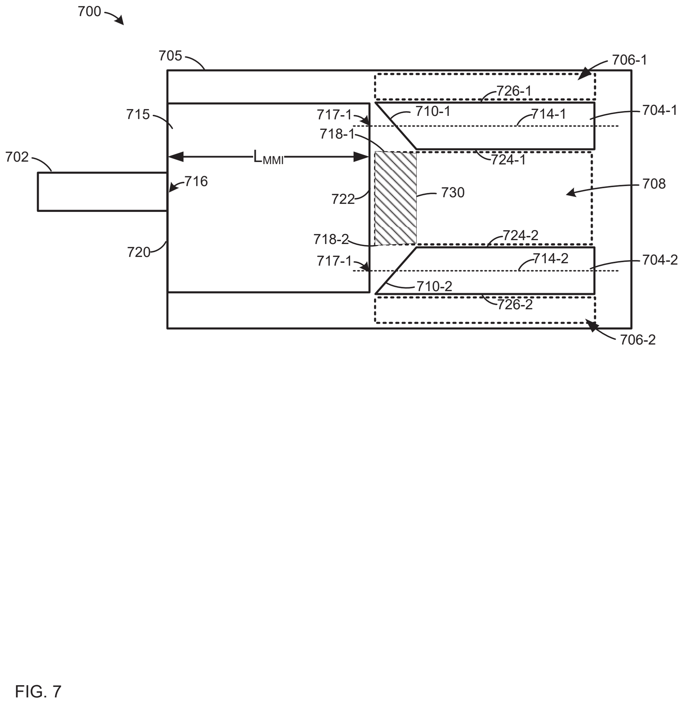

Indeed, in these examples, the waveguide photodetector 500 may be adapted to include a respective refractive-index-modifying regions 518 for each absorbing waveguide 504, though, in some instances, respective refractive-index-modifying regions 518 may be combined, for example as described with respect to FIG. 7.

Hence, in general, the MMI region 515 may be used to make a waveguide photodetector 500 more compact, for example by obviating the use of power splitters external to photodiodes with two or more absorbing waveguides and/or photodiodes (e.g., power splitters may be used to direct light to different absorbing waveguides and/or photodiodes and such power splitters may be less compact than an MMI).

Furthermore, the MMI region 551 is understood to include a first side 520 at which the input port 516 is located, and a second side 522, opposite the first side 520, at which the output ports 517 are located. A perpendicular distance between the sides 520, 522 may be the distance L_{MMI}. Furthermore, the absorbing waveguides 504 include respective first sides 524-1, 524-2 (e.g., first sides 524 and/or a first side 524) along which the n-doped semiconductor region and/or n-contact 508 is located, and the absorbing waveguides 504 include respective second sides 526-1, 526-2 (e.g., second sides 526 and/or a second side 526), opposite respective first sides 524-1, 524-2, along which the p-doped semiconductor region and/or p-contact 506 is located. As used hereafter, a first side of an absorbing waveguide will be understood to be adjacent an n-doped semiconductor region, and a second side of an absorbing waveguide will be understood to be adjacent a p-doped semiconductor region; however such a convention is merely for consistency, and any suitable "side" of an absorbing waveguide may adjacent any suitable doped semiconductor region.

Hence, in general, the waveguide photodetector 500 comprises: a multimode waveguide region 515; an input port 516 at a first side 520 of the multimode waveguide region 515; a plurality of output ports 517 at a second side 522 of the multimode waveguide region 525, the second side 522 opposite the first side 520; a main waveguide 505; and for each output port 617: an absorbing waveguide 504 integrated with the main waveguide 505, the absorbing waveguide 504 having an optical axis 514; an n-doped semiconductor region 508 along a first side 524 of the absorbing waveguide 504; a p-doped semiconductor region 506 along a second side 526 of the absorbing waveguide 504, the second side 526 opposite the first side 524; an input facet 510 at the absorbing waveguide 504, the input facet 510 forming an acute angle φ with the optical axis 514, and an interior of the input facet 510 angled towards the p-doped semiconductor region 506 (as depicted) or the n-doped semiconductor region 508, such that at least a portion of light impinging on the input facet 510 is refracted towards the p-doped semiconductor region 506 (as depicted) or the n-doped semiconductor region 508; and a refractive-index-modifying region 518 located adjacent to the input facet 510, the refractive-index-modifying region 518 comprising a region of changed refractive index relative to the main waveguide 505, the refractive-index-modifying region 518 configured to reflect respective light incident thereon toward the input facet 510.

In the example of FIG. 5, the plurality of output ports 517 comprise two output ports 517, and a pair of respective input facets 510 for respective absorbing waveguides 504 for the two output ports 517 are angled away from each other, and respective refractive-index-modifying regions 518 are located on opposite sides of the multimode waveguide region 515, for example along respective regions between an input facet 510 and a corresponding output port 517.

It is further understood that applied electric fields are adapted for the geometry of the waveguide photodetector 500, for example, with a respective applied electric field applied perpendicular to a respective optical axis 514 of each of the absorbing waveguides 504, in opposite directions due the respective locations of the n-doped semiconductor regions 508 and the shared p-doped semiconductor region 506. Indeed, similar adaptation of applied electric fields are understood to occur for the photodetectors next described.

Other configurations are within the scope of the present specification.

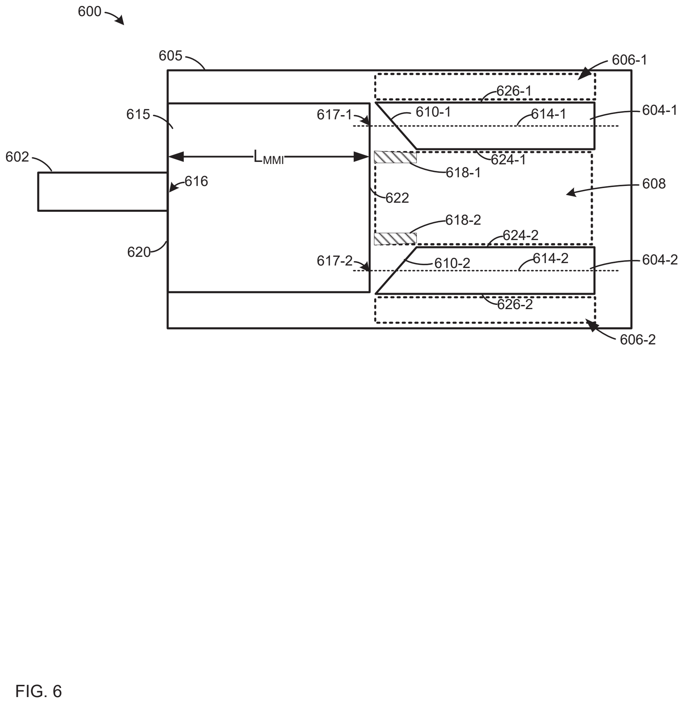

For example, attention is next directed to FIG. 6, which depicts another example waveguide photodetector 600 which is substantially similar to the waveguide photodetector 500, with like components having like numbers, but in a "600" series rather than a "500" series.

For example, the waveguide photodetector 600 comprises an input waveguide 602 similar to the input waveguide 502.

Furthermore, the waveguide photodetector 600 comprises: a multimode waveguide region 615; an input port 616 at a first side 620 of the multimode waveguide region 615; a plurality of output ports 617-1, 617-2 at a second side 622 of the multimode waveguide region 625, the second side 622 opposite the first side 620; a main waveguide 605; and for each output port 617: an absorbing waveguide 604 (e.g., of absorbing waveguides 604-1, 604-2) integrated with the main waveguide 605, the absorbing waveguide 604 having an optical axis 614 (e.g., of optical axis 614-1, 614-2); an n-doped semiconductor region 608 along a first side 624 (e.g., of first sides 624-1, 624-2) of the absorbing waveguide 604; a p-doped semiconductor region 606 (e.g., of p-doped semiconductor regions 606-1, 606-2) along a second side 626 (e.g., of second sides 626-1, 626-2) of the absorbing waveguide 604, the second side 626 opposite the first side 624; an input facet 610 (e.g., of input facet 610-1, 610-2) at the absorbing waveguide 604, the input facet 610 forming an acute angle φ with the optical axis 614, and an interior of the input facet 610 angled towards the p-doped semiconductor region 606, such that at least a portion of light impinging on the input facet 610 is refracted towards the p-doped semiconductor region; 606; and a refractive-index-modifying region 618 (e.g., of refractive-index-modifying regions 618-1, 618-2) located adjacent to the input facet 610, the refractive-index-modifying region 618 comprising a region of changed refractive index relative to the main waveguide 605, the refractive-index-modifying region 618 configured to reflect respective light incident thereon toward the input facet 610.

However, in contrast to the waveguide photodetector 500, in which a pair of respective input facets 510 are angled away from each other, at the waveguide photodetector 600, a pair of respective input facets 610 for respective absorbing waveguides 604 for the two output ports 617 are angled towards each other, and respective refractive-index-modifying regions 618 are located between the two output ports 617.

Indeed, due to the reverse angling of the input facets 610, relative to the input facets 510, the locations of the p-doped semiconductor regions 606 and the n-doped semiconductor region 608 are also reversed relative to the p-doped semiconductor region 506 and the n-doped semiconductor regions 508 of the waveguide photodetector 500. For example, the waveguide photodetector 600 comprises a shared n-doped semiconductor region 608 between the two absorbing waveguides 604 at respective first sides 624, and respective p-doped semiconductor regions 506 on respective opposite second sides 626 of the two absorbing waveguides 604. Such a configuration is provided as the input facets 610 refract light towards the respective p-doped semiconductor regions 506 for better hole migration.

While as depicted the refractive-index-modifying regions 618 are separate from each other, on other examples, the refractive-index-modifying regions 618 may be combined.

For example, attention is next directed to FIG. 7, which depicts another example waveguide photodetector 700 which is substantially similar to the waveguide photodetector 600, with like components having like numbers, but in a "700" series rather than a "600" series.

For example, the waveguide photodetector 700 comprises an input waveguide 702 similar to the input waveguide 502.

Furthermore, the waveguide photodetector 700 comprises: a multimode waveguide region 715; an input port 716 at a first side 720 of the multimode waveguide region 715; a plurality of output ports 717-1, 717-2 at a second side 720 of the multimode waveguide region 725, the second side 722 opposite the first side 722; a main waveguide 705; and for each output port 717: an absorbing waveguide 704 (e.g., of absorbing waveguides 704-1, 704-2) integrated with the main waveguide 705, the absorbing waveguide 704 having an optical axis 714 (e.g., of optical axis 714-1, 714-2); an n-doped semiconductor region 708 along a first side 724 (e.g., of first sides 724-1, 724-2) of the absorbing waveguide 704; a p-doped semiconductor region 706 (e.g., of p-doped semiconductor regions 706-1, 706-2) along a second side 726 (e.g., of second sides 726-1, 726-2) of the absorbing waveguide 704, the second side 726 opposite the first side 724; an input facet 710 (e.g., of input facet 710-1, 710-2) at the absorbing waveguide 704, the input facet 710 forming an acute angle φ with the optical axis 714, and an interior of the input facet 710 angled towards the p-doped semiconductor region 706, such that at least a portion of light impinging on the input facet 710 is refracted towards the p-doped semiconductor region; 706; and a refractive-index-modifying region 718 (e.g., of refractive-index-modifying regions 718-1, 718-2) located adjacent to the input facet 710, the refractive-index-modifying region 718 comprising a region of changed refractive index relative to the main waveguide 705, the refractive-index-modifying region 718 configured to reflect respective light incident thereon toward the input facet 710.

Similar to the waveguide photodetector 600, a pair of respective input facets 710 for respective absorbing waveguides 704 for the two output ports 717 are angled towards each other, and respective refractive-index-modifying regions 718 are located between the two output ports 717. However, in contrast to the waveguide photodetector 600, the respective refractive-index-modifying regions 718 are joined between the two output ports 717, for example forming as a single trough and/or a single (e.g., etched) region 730 at opposite sides of the single region 730. The region 730 may have other benefits, described in more detail below.

Yet further configurations are within the scope of the present specification.

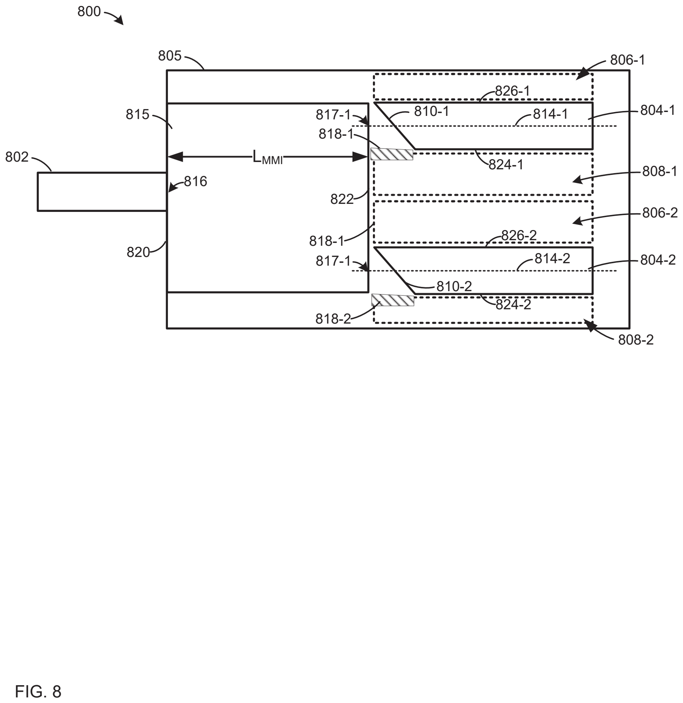

For example, attention is next directed to FIG. 8, which depicts another example waveguide photodetector 800 which is substantially similar to the waveguide photodetector 500, with like components having like numbers, but in an "800" series rather than a "500" series.

For example, the waveguide photodetector 800 comprises an input waveguide 802 similar to the input waveguide 502.

Furthermore, the waveguide photodetector 800 comprises: a multimode waveguide region 815; an input port 816 at a first side 820 of the multimode waveguide region 815; a plurality of output ports 817-1, 817-2 at a second side 820 of the multimode waveguide region 825, the second side 822 opposite the first side 822; a main waveguide 805; and for each output port 817: an absorbing waveguide 804 (e.g., of absorbing waveguides 804-1, 804-2) integrated with the main waveguide 805, the absorbing waveguide 804 having an optical axis 814 (e.g., of optical axis 814-1, 814-2); an n-doped semiconductor region 808 (e.g., of n-doped semiconductor regions 808-1, 808-2) along a first side 824 (e.g., of first sides 824-1, 824-2) of the absorbing waveguide 804; a p-doped semiconductor region 806 (e.g., of p-doped semiconductor regions 806-1, 806-2) along a second side 826 (e.g., of second sides 826-1, 826-2) of the absorbing waveguide 804, the second side 826 opposite the first side 824; an input facet 810 (e.g., of input facet 810-1, 810-2) at the absorbing waveguide 804, the input facet 810 forming an acute angle φ with the optical axis 814, and an interior of the input facet 810 angled towards the p-doped semiconductor region 806, such that at least a portion of light impinging on the input facet 810 is refracted towards the p-doped semiconductor region; 806; and a refractive-index-modifying region 818 (e.g., of refractive-index-modifying regions 818-1, 818-2) located adjacent to the input facet 810, the refractive-index-modifying region 818 comprising a region of changed refractive index relative to the main waveguide 805, the refractive-index-modifying region 818 configured to reflect respective light incident thereon toward the input facet 810.

However, in contrast to the waveguide photodetectors 500, 600, 700, where input faces of a pair of absorbing waveguides either face away from each other or toward each other (e.g., in different directions), the input faces 810 of the absorbing waveguides 804 are in a same direction. As such, the region between the absorbing waveguides 804 is adapted to include both an n-doped semiconductor region 808-1 adjacent the first side 824-1 of one absorbing waveguide 804-1, and p-doped semiconductor region 806-2 adjacent the second side 86-2 of the other absorbing waveguide 804-2.

More particularly, at the waveguide photodetector 800: the plurality of output ports 817 comprise a first outport port 817-1 and a second output port 817-2; a pair of respective input facets 810 for respective absorbing waveguides 804 for the two output ports 817 are angled in a same direction; a first input facet 810-1, associated with the first output port 817-1, is angled towards the second output port 817-2; a second input facet 810-2 associated with the second output port 817-2 is angled towards the second output port 817-2; a first respective refractive-index-modifying region 818-1 for the first input facet 810-1 is located between the two output ports 817 (e.g., and otherwise positioned adjacent the region between the first input facet 810-1 and the first output port 817-1, and/or along the first input facet 810-1); and a second respective refractive-index-modifying region 818-2 for the second input facet 810-2 is located adjacent the second output port 817-2 (e.g., and otherwise positioned adjacent the region between the second input facet 810-2 and the second output port 817-2, and/or along the second input facet 810-2).

It is furthermore understood that the configuration of the waveguide photodetector 800 may be reversed, for example according to a mirror image thereof, such that the input facets 810 are in a direction of the first output port 817-1, with the locations of the doped regions 806, 808 and the refractive-index-modifying regions 818 adjusted accordingly.

Regardless of a direction of the input facets 810, an applied electric field may be common to both absorbing waveguides in the waveguide photodetector 800.

Returning to FIG. 7, it is yet further understood the presence of the single region 730 between the output ports 717 may have further functionality.

For example, the single region 730 may also serve to terminate the MMI region 715 and avoid generating a two-fold image of light to further combine and interfere, as the single region 730 also causes an abrupt change in refractive index in the main waveguide 705 adjacent the MMI region 715 between the output ports 717. For example, the single region 730 may assist at containing light in the MMI region 715 between the output ports 717 (e.g., by reflecting any light exiting the MMI region 715 between the output ports 717 back towards the MMI region 715), which may better constrain light exiting the MMI region 715 to the output ports 7171, which may overall enhance the responsivity of the waveguide photodetector 700.

Indeed, any of the waveguide photodetectors 500, 600, 700, 800 may be adapted to include a refractive-index-modifying region (e.g., similar to the single region 730) that extends along a respective MMI region at a respective second side between respective output ports, though such a refractive-index-modifying region is not provided in the regions between input facets and output ports so as to not interfere with light entering the input facets.

In a non-limiting embodiment of the waveguide photodetector of the present invention, the main waveguide comprises silicon, the n-doped semiconductor region comprises n-doped silicon, and the p-doped semiconductor region comprises p-doped silicon.

In a non-limiting embodiment of the waveguide photodetector of the present invention, the absorbing waveguide comprises germanium.

It is further understood that instance of the term "configured to", such as "a computing device configured to...", "a processor configured to...", "a controller configured to...", and the like, may be understood to include a feature of a computer-readable storage medium having stored thereon program instructions that, when executed by a computing device and/or a processor and/or a controller, and the like, may cause the computing device and/or the processor and/or the controller to perform a set of operations which may comprise the features that the computing device and/or the processor and/or the controller, and the like, are configured to implement. Hence, the term "configured to" is understood not to be unduly limiting to means plus function interpretations, and the like.

Furthermore, descriptions of one processor and/or controller and/or device and/or engine, and the like, configured to perform certain functionality is understood to include, but is not limited to, more than one processor and/or more than one controller and/or more than one device and/or more than one engine, and the like performing such functionality.

It is understood that for the purpose of this specification, language of "at least one of X, Y, and Z" and "one or more of X, Y and Z" may be construed as X only, Y only, Z only, or any combination of two or more items X, Y, and Z (e.g., XYZ, XY, YZ, XZ, and the like). Similar logic may be applied for two or more items in any occurrence of "at least one..." and "one or more..." language.

The terms "about", "substantially", "essentially", "approximately", and the like, are defined as being "close to", for example as understood by persons of skill in the art. In some examples, the terms are understood to be "within 10%," in other examples, "within 5%", in yet further examples, "within 1%", and in yet further examples "within 0.5%".

Persons skilled in the art will appreciate that there are yet more alternative examples and modifications possible, and that the above examples are only illustrations of one or more examples. The scope, therefore, is only to be limited by the claims appended hereto.

## Claims

1. A waveguide photodetector comprising:
a multimode waveguide region;
an input port at a first side of the multimode waveguide region;
a plurality of output ports at a second side of the multimode waveguide region, the second side opposite the first side;
a main waveguide; and
for each output port:
an absorbing waveguide integrated with the main waveguide, the absorbing waveguide having an optical axis;
an n-doped semiconductor region along a respective first side of the absorbing waveguide;
a p-doped semiconductor region along a respective second side of the absorbing waveguide, the respective second side opposite the respective first side;
an input facet at the absorbing waveguide, the input facet forming an acute angle with the optical axis, and an interior of the input facet angled towards the p-doped semiconductor region or the n-doped semiconductor region, such that at least a portion of light impinging on the input facet is refracted towards the p-doped semiconductor region or the n-doped semiconductor region; and
a refractive-index-modifying region located adjacent to the input facet, the refractive-index-modifying region comprising a region of changed refractive index relative to the main waveguide, the refractive-index-modifying region configured to reflect respective light incident thereon toward the input facet.

2. The waveguide photodetector of claim 1, wherein the plurality of output ports comprise two output ports, and a pair of respective input facets for respective absorbing waveguides for the two output ports are angled away from each other, and respective refractive-index-modifying regions are located on opposite sides of the multimode waveguide region.

3. The waveguide photodetector of claim 1, wherein the plurality of output ports comprise two output ports, and a pair of respective input facets for respective absorbing waveguides for the two output ports are angled towards each other, and respective refractive-index-modifying regions are located between the two output ports.

4. The waveguide photodetector of claim 3, wherein the respective refractive-index-modifying regions are joined between the two output ports.

5. The waveguide photodetector of claim 1, wherein the plurality of output ports comprise a first outport port and a second output port,
wherein a pair of respective input facets for respective absorbing waveguides for the first outport port and the second output port are angled in a same direction,
wherein a first input facet associated with the first output port is angled towards the second output port,
wherein a second input facet associated with the second output port is angled towards the second output port,
wherein a first respective refractive-index-modifying region for the first input facet is located between the first outport port and the second output port, and
wherein a second respective refractive-index-modifying region for the second input facet is located adjacent the second output port.

6. The waveguide photodetector of claim 1, wherein the refractive-index-modifying region causes an abrupt change in an index of refraction in the main waveguide in a direction of a reflected portion of the light impinging on the input facet.

7. The waveguide photodetector of claim 1, wherein an index of refraction of the refractive-index-modifying region is less than a respective index of refraction of the main waveguide.

8. The waveguide photodetector of claim 1, wherein the refractive-index-modifying region comprises a refractive-index-modifying region in the main waveguide located adjacent to the input facet.

9. The waveguide photodetector of claim 1, wherein the refractive-index-modifying region comprises a trough in the main waveguide.

10. The waveguide photodetector of claim 1, wherein the refractive-index-modifying region comprises an absence of main waveguide material, and wherein the absence is filled with air.

11. The waveguide photodetector of claim 1, wherein the refractive-index-modifying region comprises an absence of main waveguide material, and wherein the absence is filled with an oxide material.

12. The waveguide photodetector of claim 1, wherein the refractive-index-modifying region comprises an absence of main waveguide material, and wherein the absence is filled with a transparent material.

13. The waveguide photodetector of claim 1, wherein the refractive-index-modifying region comprises an absence of main waveguide material, and wherein the absence is filled with a semitransparent material.

14. The waveguide photodetector of claim 1, wherein a depth of the refractive-index-modifying region is about half a respective depth of the main waveguide.

15. The waveguide photodetector of claim 1, wherein the acute angle is between about 20° and about 80° or the acute angle is between about 30° and about 70° or the acute angle is between about 45° and about 60° or the acute angle is at about 45°.
